# EUROPEAN PATENT SPECIFICATION

(11) **EP 2 348 537 B1**
(45) Date of publication and mention of the grant of the patent: **23.01.2013**
(21) Application number: 11151966.6
(22) Date of filing: 25.01.2011
(51) Int. Cl.: H01L 31/02, H01L 31/101, G01C 3/00

(54) **Electro-optical demodulator based on buried photodiode**
Elekro-optischer Demodulator mit vergrabener Photodiode
Démodulateur électro-optique avec photodiode enterée

(30) Priority: 26.01.2010 IT MI20100091
(43) Date of publication of application: 27.07.2011
(73) Proprietor: Fondazione Bruno Kessler, 38122 Trento (IT)
(72) Inventor: Pancheri, Lucio, 38100 Trento (IT); Stoppa, David, 38072 Calavino (IT); Massari, Nicola, 38057 Pergine Valsugana (IT)
(74) Representative: Fiume, Orazio

(56) References cited:
- US-A1- 2006 192 938
- US-A1- 2007 158 770
- US-A1- 2009 134 396

## Description

### Field of the invention

The present invention relates to an electro-optical demodulator based on buried photodiode.

### State of the art

Various applications require the demodulation of a high frequency light radiation in order to obtain the phase thereof. A first example concerns the so-called Time-of-Flight (TOF) which relates to measuring the travel time of electro-magnetic radiation in a transmission medium. A second example concerns the so-called "Fluorescence Lifetime Imaging" (FLIM) which relates to measuring the decay rate of the radiation emitted from fluorescent molecules.

Techniques based on the photonic demodulation by means of "photo-gate" are known and indicated by the abbreviation PMD (Photonic Mixing Device), applied to said Time-of-Flight measurements and to said FLIM measurements. The use of buried photodiodes, applied to said FLIM measurements, is also known.

In the case of PMDs, the photo-generated charge is transferred at high speed between two or more photo-gates, so as to carry out said demodulation in the charge domain.

In the case of implementation of buried photodiodes, the charge is transferred between two buried photodiodes or between a buried photodiode and an n+ type collecting junction.

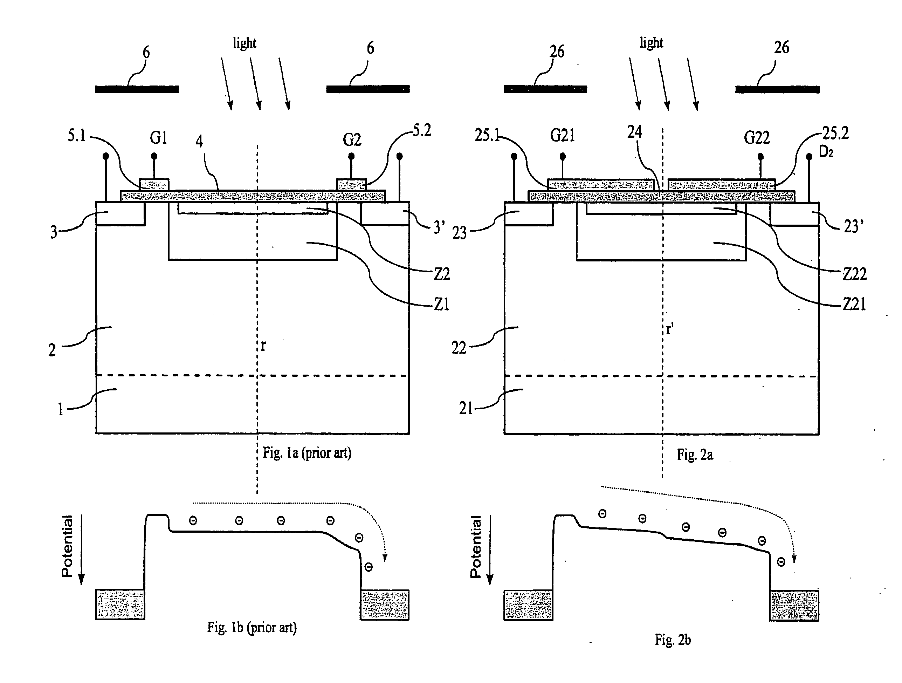

An electro-optical demodulator obtained from a pinned type photodiode equipped with two gates is shown in figures 1 a and 1 b of the prior art.

Said device, which is symmetrical with respect to a barycentric axis r, comprises an epitaxial layer (p-) 2 formed on a sub-layer (p+) 1 and comprising, on an upper face, a first pair of n+ junctions defining first 3 and second 3' collectors, respectively. Said two junctions are symmetrically arranged close to the edges of the device, according to the section-view. Deposited between said first pair of junctions 3 and 3' there is a silicon oxide layer 4. Close to each of said first junctions 3 and 3', on said silicon oxide layer 4, there are first 5.1 and second 5.2 polysilicon gates.

In the epitaxial layer 2, under said silicon oxide layer 4, n and p-type doped zones are defined. In particular, a first n-type doped zone Z1 is defined in said epitaxial layer 2; within said zone Z1 there is another doped zone Z2, of type p, which extends over a smaller depth as compared to said first zone Z1 and is facing said silicon oxide layer 4. Shields 6 may be provided for the light radiation, adapted to uncover the sensitive part of the sensor, i.e. the part between said first 5.1 and second 5.2 polysilicon gates.

Figure 1 b according to the prior art depicts the pattern of the electrostatic potential minimum according to a transversal direction in figure 1 a, when the voltage applied to the gate electrode G1 is zero, whereas the voltage applied to the gate electrode G2 is high enough to suppress the potential barrier between the region n of the buried photodiode Z1 and the collector 3'. The dotted arrow indicates the movement direction of the photo-generated electrons which are collected by collector 3'.

The example of the prior art herewith commented can be found in US2006192938, whom features are in the preamble of claim 1.

However, said device is not capable of carrying out high frequency demodulation, because of a too lengthy transfer time of the photo-generated electrons between the buried photodiode and the n+ type junctions. The lengthy transfer time is due to the lack of a lateral electric field in the middle part of the device, where the electrostatic potential is constant.

### Summary of the invention

It is the object of the present invention to provide an electro-optical demodulator based on buried photodiode adapted to solve the aforesaid problem.

The subject of the present invention is an electro-optical demodulator based on buried photodiode in accordance with claim 1.

Advantageously, the pattern of the electric potential according to a transversal direction to the demodulator decreases monotonically in an extended region of the device section. Thereby, the electron collection may occur in a short time and permit the demodulation of the optical signals having higher frequency with respect to the known art.

The present invention is particularly applied in the so-called "phase sensitive optical detection" applications, e.g. Time-of-Flight Range Imaging and Fluorescence Lifetime Imaging.

The dependent claims describe preferred embodiments of the invention, thus forming an integral part of the present description.

### Brief description of the drawings

Further features and advantages of the invention will become more apparent in view of the detailed description of preferred, but not exclusive, embodiments of an electro-optical demodulator based on buried photodiode, shown by way of a nonlimiting example, with the aid of the accompanying drawings in which:
Figures 1 a and 1 b depict a sectional view of an electro-optical demodulator based on buried photodiode according to the known art and the related pattern of the electric potential minimum in the transversal direction, respectively.
Figures 2a and 2b depict a sectional view of an electro-optical demodulator based on buried photodiode according to the present invention and the related pattern of the electric potential minimum in the transversal direction, respectively.

The same reference numbers and letters in the figures identify the same elements or components.

### Detailed description of a preferred embodiment of the invention

Said device comprises an epitaxial layer (p-) 22 formed on a sub-layer (p+) 21 and comprising, on an upper side, a pair of n+ junctions 23 and 23'. In a part between said pair of n+ junctions 23 and 23', there is a silicon oxide layer 24. Close to each junction of said pair of n+ junctions 23, on said silicon oxide layer 24 and close to two opposite edges, there are first 25.1 and second 25.2 polysilicon gates.

The first 25.1 and second 25.2 polysilicon gates extend from the external edges to the middle line of the device, indicated by the symmetrical barycentric axis r', until facing each other, without touching, i.e. being separate. The separation distance between the two gates 25.1 and 25.2 depends on the technology employed. The smaller the distance between the gates, the more efficient the behaviour of the sensor.

The surface of the silicon oxide layer 24 is covered by said first 25.1 and second 25.2 polysilicon gates for at least the 50% with an ideal value of 100%. The 100% is unreachable due to the presence of the separation between the gates. In the epitaxial layer 22, under said silicon oxide layer 24 and between said pair of n+ junctions 23 and 23', n and p-type doped zones are defined. In particular, a first n-type doped zone Z1 is defined in said epitaxial layer 22; within said zone Z21, there is a second doped zone Z22, of type p, which extends over a smaller depth as compared to said first zone Z21 and is facing said silicon oxide layer 24.

As shown with the aid of figure 2b, the potential difference applied to the gate electrodes G21 and G22 advantageously determine a lateral electric field in the device, which extends over the entire length of the buried layer n Z21 and which contributes to accelerating the transfer of electrons towards the collectors 23 and 23', thus permitting a broader demodulation band to be obtained as required by certain applications.

Said electric field is correlated with a decreasing potential minimum along a direction joining said pair of junctions 23 and 23' over the entire length of the device, thus permitting a quick collection of the electrons by collector 23'.

Said potential minimum shows a decreasing trend from the first gate 25.1 to the second gate 25.2, which is correlated to the percentage of surface of the silicon oxide layer 24 covered by the gates 25.1 and 25.2 and which is a consequence of the feature that the gates are close between each other.

Conversely, in the structure in figure 1 a according to the prior art, the potential minimum is constant in the middle part of the device, therefore the electron collection time by means of collector 3' is lengthier.

Furthermore, the provision of the described structure does not advantageously involve additional production costs, as it is within the reach of known manufacturing means and techniques.

Shields 26 may be provided for the light radiation, adapted to uncover the sensitive part of the sensor, i.e. the part between said junctions 23 and 23'.

The elements and features disclosed in the various preferred embodiments may be combined without however departing from the scope of protection of the present application, which is however only defined by the appended claims.

## Claims

1. An electro-optical demodulator based on buried photodiode comprising: an epitaxial layer (22); a first pair of n+ junctions defining a pair of collectors (23, 23') formed close to opposite edges of said epitaxial layer (22); a silicon oxide layer (24) formed on said epitaxial layer (22) extending between said pair of collectors (23, 23'); n-type (Z21) and p-type (Z22) doped zones under said silicon oxide layer (24); a pair of polysilicon gates (25.1, 25.2), formed on said silicon oxide layer (24), said gates extending from the edges of said silicon oxide layer (24) to a middle line (r') of the demodulator, without touching each other **characterized in that** the surface of the silicon oxide layer (24) is covered by first (25.1) and second (25.2) polysilicon gates for at least the 50% with an ideal value of 100%, but still without touching code other.

2. An electro-optical demodulator according to claim 1, wherein said polysilicon gates (25.1, 25.2) are disposed as close as possible to each other.

3. A demodulator according to claim 1, wherein said n-type doped zone (Z21) is defined in said epitaxial layer (22).

4. A demodulator according to claim 3, wherein said p-type doped zone (Z22) is defined within said n-type doped zone (Z21), extending over a smaller depth as compared to said n-type doped zone (Z21) and facing said silicon oxide layer (24).

## Patentansprüche

1. Elektrooptischer Demodulator, der auf einer vergrabenen Photodiode beruht, wobei der elektrooptische Demodulator umfasst: eine Epitaxieschicht (22); ein erstes Paar von n+-Übergängen, die ein Paar von Kollektoren (23, 23') definieren, die in der Nähe gegenüberliegender Ränder der genannten Epitaxieschicht (22) ausgebildet sind; eine Siliciumoxidschicht (24), die zwischen dem genannten Paar von Kollektoren (23, 23') verlaufend auf der genannten Epitaxieschicht (22) ausgebildet ist; eine n-dotierte Zone (Z21) und eine p-dotierte Zone (Z22) unter der genannten Siliciumoxidschicht (24); ein Paar Polysilicium-Gates (25.1, 25.2), die auf der genannten Siliciumoxidschicht (24) ausgebildet sind, wobei die genannten Gates von den Rändern der genannten Siliciumoxidschicht (24) zu einer Mittellinie (r') des Demodulators verlaufen, ohne sich zu berühren, **dadurch gekennzeichnet, dass** die Oberfläche der Siliciumoxidschicht (24) zu wenigstens 50 %,bei einem Idealwert von 100 %, jedoch immer noch ohne sich zu berühren, von einem ersten Polysilicium-Gate (25.1) und von einem zweiten Polysilicium-Gate (25.2)bedeckt ist.

2. Elektrooptischer Demodulator gemäß Anspruch 1, bei dem die genannten Polysilicium-Gates (25.1, 25.2) so nahe wie möglich beieinander angeordnet sind.

3. Demodulator gemäß Anspruch 1, bei dem diegenannte n-dotierte Zone (Z21) in der genannten Epitaxieschicht (22) definiert ist.

4. Demodulator gemäß Anspruch 3, bei dem die genannte p-dotierte Zone (Z22) innerhalb der genannten n-dotierten Zone (Z21) definiert ist, wobei sie im Vergleich zu der genannten n-dotierten Zone (Z21) über eine kleinere Tiefe verläuft und der genannten Siliciumoxidschicht (24) zugewandt ist.

## Revendications

1. Démodulateur électro-optique basé sur une photodiode enterrée comprenant: une couche épitaxiale (22); une première paire de jonctions n+ définissant une paire de collecteurs (23, 23') formés à proximité des bords opposés de ladite couche épitaxiale (22); une couche d'oxyde de silicium (24) formée sur ladite couche épitaxiale (22) s'étendant entre ladite paire de collecteurs (23, 23'); des zones dopées de type n (Z21) et de type p (Z22) sous ladite couche d'oxyde de silicium (24); une paire de grilles en polysilicium (25.1, 25.2) formées sur ladite couche d'oxyde de silicium (24), lesdites grilles s'étendant des bords de ladite couche d'oxyde de silicium (24) vers une ligne médiane (r') du démodulateur, sans se toucher, **caractérisé en ce que** la surface de la couche d'oxyde de silicium (24) est couverte par les première (25.1) et deuxième (25.2) grilles en polysilicium pour au moins 50% avec une valeur idéale de 100% mais toujours sans se toucher.

2. Démodulateur électro-optique selon la revendication 1, dans lequel lesdites grilles de polysilicium (25.1, 25.2) sont disposées aussi près que possible l'une à l'autre.

3. Démodulateur selon la revendication 1, dans lequel ladite zone dopée de type n (Z21) est définie dans ladite couche épitaxiale (22).

4. Démodulateur selon la revendication 3, dans lequel ladite zone dopée de type p (Z22) est définie dans ladite zone dopée de type n (Z21), s'étendant sur une plus petite profondeur en comparaison avec ladite zone dopée de type n (Z21) et faisant face à ladite couche d'oxyde de silicium (24).
